# EUROPEAN PATENT APPLICATION

(11) **EP 4 831 341 A1**
(43) Date of publication of application: **28.10.2026**
(21) Application number: 25172215.3
(22) Date of filing: 24.04.2025
(51) Int. Cl.: C23C 14/34, C23C 14/50, C23C 14/56

(54) **SUBSTRATE TRANSPORTATION ARRANGEMENT FOR A SUBSTRATE TREATMENT SYSTEM**

(71) Applicant: NEOVAC GmbH, 63791 Karlstein (DE)
(72) Inventor: SCHNEIDER, Stefan, 61118 Bad Vilbel (DE); HERZOG, André, 63755 Alzenau (DE); MUSTAFI, Emir, 40699 Erkrath (DE); PORTKA, Martin, 35396 Gießen (DE)
(74) Representative: Weilnau, Carsten

(57) **Abstract**

The present disclosure relates to a substrate transportation arrangement (10) for feeding an elongated substrate (28) along a transportation direction (x, z) inside a vacuum chamber (11) confined by a chamber wall (12), the substrate transportation arrangement (1) comprising:
- a rotatable drum (30) configured to hold at least a part of the substrate (28) in a coiled configuration as a substrate coil (24, 26) within the vacuum chamber (11),
- an elongated shaft (32) defining an axis of rotation (R), rotatably connected to the rotatable drum (30) and configured to intersect the chamber wall (12),
- a drive (38) coupled to the elongated shaft (32) and configured for an operation and an arrangement outside the vacuum chamber (11) to initiate and/or to control a rotation of the rotatable drum (30) with respect to the axis of rotation (R) via the elongated shaft (32).

## Description

The present invention relates to the field of coating substrates, and in particular to the field of coating metallic substrates with a metallic coating or anti-corrosive coating. In further aspects the present invention relates to a substrate transportation arrangement for a substrate treatment system and to a respective substrate treatment system. In another aspect the invention relates to a method of treating and/or transporting a substrate.

### Background

Coating materials, such as a gaseous metal or metallic layers may be coated on a surface of a metallic substrate, such as a single sheet or steel strip. Here, the substrate is arranged in a coating- or vacuum atmosphere. In vacuum deposition there may be applied various deposition methods, by way of which a solid or liquid coating material, e.g. a metallic coating material, is evaporated. This typically implies a heating of the evaporation material up to an evaporation temperature, e.g. in a vacuum atmosphere, to transition into a gaseous or evaporated state. Once the evaporation material is sufficiently evaporated a thin-film is formed on the substrate as a coating.

Typically and for physical vapor deposition (PVD) of substrates on a rather large scale it is quite challenging to precisely control a deposition process inside the vacuum atmosphere. It is also quite challenging to control a geometric expansion of evaporated material inside a vacuum chamber.

For obtaining an optimal anticorrosive coating on a metallic substrate, it may be desirable to apply a coating system comprising numerous layers of different coating materials. Also, and during the coating process the metallic substrate should not be exposed to overly high temperatures or thermal loads. On the other hand, conducting a coating at comparatively low temperatures may be detrimental to the quality of the coating. Moreover, when applying a multi-layer coating or when applying layers of different materials onto the surface of the substrate, the mutual adhesion of the individual layers as well as the stoichiometric composition of the layers may be difficult to control.

Production lines for finishing strip-shaped substrates are known. Finishing by means of vacuum coating is carried out in such production lines in batch operation. This means that the system is filled with a batch, finished and then unloaded. Coating can be carried out using various processes such as PVD (Physical Vapor Deposition), in particular sputtering or vapor deposition.

A fundamental problem with known systems for vacuum coating of strip-shaped substrates is the design-related limitation of the strip thickness. Above a certain strip thickness, the known systems are no longer able to unwind the strips in sufficient quality and rewind them after coating. Such systems are designed for plastic films, paper or even very thin metal foils. The winding devices used are not sufficiently strong to absorb the resulting forces. In conventional vacuum coating systems for strip-shaped substrates, the substrate material is supplied on carrier sleeves. These carrier sleeves are placed on carrier axles outside the coating system and manually clamped to prevent slippage. The fully assembled carrier axles are inserted into two bearing blocks in the system and connected to the drive. However, steel strip coils are processed and transported without a carrier core, so it is not possible to pick them up using the process described above. Furthermore, belt transports have a tendency to run sideways during transportation, which leads to a displacement of the belt in the winding system. The technologies usually used to guide the strip, such as spreader rollers, deflection rollers with bearings that can be displaced on one side, rewinders that oscillate transversely to the winding direction, etc., no longer work above a certain strip thickness, especially for steel strip.

One known solution is to tension the strip freely between the unwinding and rewinding system during the coating process. However, such systems are severely limited. The strip tends to sag and the sideways movement cannot be corrected. Furthermore, such systems can only be built horizontally and require a disproportionately large footprint. In addition, thicker belts, especially those made of stable materials such as high-strength metals, have a strong spring effect. Changing of the strips may involve a high risk and the system may be damaged if the strip is torn or becomes subject to rupture.

It is therefore an aim of the present development to provide improvements to the substrate transport inside a vacuum chamber. The improvement should be particularly suitable for transportation and handling of elongated strips of steel, which may be provided in a coiled or wrapped configuration, e.g. in form of a substrate coil. The improvement should be less susceptible to a potential rupture of the substrate and should provide a protection mechanism to prevent inadvertent rupture of the substrate inside the vacuum environment. Moreover, there should be provided improvements to the substrate transportation in general, which are suitable for substrate transportation inside a vacuum environment or vacuum chamber. At the same time, the substrate transportation arrangement should be practical in use and in terms of maintenance. It should be cost efficient to manufacture. The substrate transportation arrangement should further provide and enable installation of a substrate treatment system, such as a coating device or coating arrangement with limited installation space or installation footprint.

### Summary

The above-mentioned drawbacks and problems will be solved by a substrate transportation arrangement, by a substrate treatment system and by a method of treating a substrate in a vacuum chamber as defined by the features of the independent claims. Numerous examples and variants of the respective technical solution are subject matter of dependent claims, respectively.

In a first aspect there is provided a substrate transportation arrangement for feeding an elongated substrate along a transportation direction inside a vacuum chamber. The vacuum chamber is confined by a chamber wall. The substrate transportation arrangement comprises a rotatable drum, which is configured to hold at least a part of the substrate, e.g., a strip of a substrate material in a coiled configuration as a substrate coil within the vacuum chamber.

The substrate transportation arrangement further comprises an elongated shaft defining an axis of rotation. The elongated shaft is rotatably connected to the rotatable drum and is configured to intersect the chamber wall. The elongated shaft and/or the rotatable drum are configured to rotate with respect to the axis of rotation as defined by the elongated shaft. The elongated shaft may be of cylindrical or tubular shape. Here, the axis of rotation may extend along a longitudinal centerline of the elongated shaft.

The substrate transportation arrangement further comprises a drive, which is coupled to the elongated shaft. The drive may be mechanically coupled and/or mechanically connected to the elongated shaft. The drive is further configured for an operation and an arrangement or location outside the vacuum chamber. The drive is further configured to initiate or to induce and/or to control a rotation of the rotatable drum with respect to the axis of rotation via the elongated shaft.

In other words, the drive, which is configured for installation outside the vacuum chamber, may be connected to the drum via the elongated shaft, wherein the elongated shaft traverses the boundary of the vacuum chamber. Accordingly, the elongated shaft extends through the chamber wall. A proximal end of the elongated shaft may be in torque proof engagement with the drive. An opposite and hence a distal longitudinal end of the elongated shaft may be rotatably connected to the rotatable drum. It may be fixed and/or connected to the rotatable drum, such that a rotation of the elongated shaft with respect to the axis of rotation induces a respective rotation of the rotatable drum.

The rotatable drum may be coaxial with the elongated shaft. In some examples, the rotatable drum may be in a torque prove and hence in a torque transmitting mechanical engagement with the elongated shaft. Here, the rotatable drum may be located at an axial offset to the elongated shaft as seen in longitudinal direction of the elongated shaft and/or of the axis of rotation. Hence, with some examples, an axis of rotation of the rotatable drum may be coaxial and may coincide with the axis of rotation of the elongated shaft, which may act as a drive shaft for rotating the rotatable drum. According to some examples, the distal longitudinal end of the elongated shaft is flush with a distal end section of the rotatable drum. The rotatable drum may be mounted on the elongated shaft and may be rotationally supported by the elongated shaft.

In some examples, the axis of rotation of the rotatable drum may extend parallel to the axis of rotation of the elongated shaft. In some examples, the axis of rotation of the rotatable drum may be oriented at a particular angle relative to the elongation of the axis of rotation of the elongated shaft. Here, there may be provided a transmission or transmission gear between the rotatable drum inside the vacuum chamber and the elongated shaft extending through the chamber wall and hence intersecting the chamber wall.

With some examples and when the rotatable drum is fixed to the elongated shaft there may be provided a rather direct torque transmission between the rotatable shaft and the rotatable drum. In some examples the rotatable drum and the elongated shaft may be rigidly attached to each other, i.e., in a non-movable manner. A rotation of the elongated shaft may then transition into a respective rotation or rotational motion of the rotatable drum. In this way, it can be provided that a drive for inducing or initiating a rotation of the rotatable drum can be placed, installed and hence arranged outside the vacuum chamber, which allows a rather easy and straightforward implementation of the drive. Hence, the drive does not have to be operated inside the vacuum environment or inside the vacuum chamber.

According to a further example a longitudinal distal end of the elongated shaft is connected or fixed to the rotatable drum. The longitudinal distal end of the elongated shaft may be fixedly attached to the rotatable drum. It may be non-movably fixed and may be rotationally locked to the rotatable drum, such that a rotation of the elongated shaft with respect to the axis of rotation initiates and/or leads to a respective rotation of the rotatable drum.

According to a further example the rotatable drum comprises a sidewall and at least one clamping element movable relative to the sidewall along a radial direction with respect to the axis of rotation and/or with respect to a symmetry axis of the rotatable drum. The clamping element is movable between a release position and a clamping position to selectively engage with an inside sidewall of the substrate coil.

Typically, the substrate coil, e.g., a coiled strip of substrate material comprises an inside sidewall of a predefined diameter or cross-section. The diameter or cross-section of the inside sidewall of the substrate coil may be slightly larger than an outside diameter of the sidewall of the rotatable drum, which may be of tubular shape. In this way, the substrate coil with its inside sidewall can be mounted onto the sidewall of the rotatable drum in an axial direction, hence along the axis of rotation of the elongated shaft and/or of the rotatable drum. It may be then provided, that the clamping element is moved from a radially inwardly located release position into a radially outwardly located clamping position such as to exert a radially outwardly directed force effect or pressure onto the inside surface of the inside sidewall of the substrate coil.

In this way, there can be provided a friction fit between the rotatable drum and the substrate coil such that the substrate coil can be fixed in a slip free manner on the rotatable drum.

According to some examples the rotatable drum comprises numerous clamping elements, which are likewise movable relative to the sidewall along the radial direction between the release position and their clamping position. In some examples, there may be provided at least two or at least three clamping elements, which may be arranged equiangularly or equidistantly along the circumferential direction of the e.g. tubularly-shaped sidewall of the rotatable drum. In this way, there can be provided a multiple and hence improved clamping between the rotatable drum and the substrate coil.

According to some examples the substrate coil may be provided on a standardized sleeve of standardized inside diameter or inside cross-section. Here, the support sleeve of the substrate coil may not belong to the substrate strip but may serve as an inner core onto which the substrate strip can be coiled. According to further examples the substrate coil is provided without such an inside tubular-shaped core. Rather, the inside sidewall of the substrate coil may be directly formed or provided or constituted by an innermost wrap or inner cross-section of the coiled strip material or substrate material. Here, and due to manufacturing tolerances, the inside diameter or inside cross-section of the substrate coil may slightly vary. However, with at least one or numerous radially movable clamping elements, such geometric tolerances can be easily compensated.

According to a further example, the substrate transportation arrangement further comprises a clamping arrangement. The clamping arrangement comprises a clamping actuator and a transmission rod to mechanically couple the clamping actuator with the at least one clamping element. The clamping actuator may be also arranged outside the vacuum chamber. Here, the transmission rod may provide a respective mechanical transmission between the clamping actuator and the clamping element. Hence, a force effect provided by the clamping actuator can be transmitted or transferred via the movable transmission rod through the sidewall or chamber wall of the vacuum chamber to induce and/or to control a respective radial movement of the at least one clamping element.

When the substrate transportation arrangement, and hence when the rotatable drum is provided with a number or with numerous individual clamping elements, the number of clamping elements may be mechanically coupled or connected to the clamping actuator by one and the same transmission rod. It may be also possible, that the clamping actuator is connected or mechanically coupled to a number of clamping actuators by way or through a number of transmission rods, respectively.

According to another example the clamping actuator is configured for arrangement outside the vacuum chamber. The clamping actuator may be unsuitable for an arrangement and/or operation inside the vacuum chamber. According to some examples the transmission rod extends through the chamber wall and hence intersects the chamber wall. In this way, and like the drive for the rotatable drum, also the clamping actuator can be located and arranged outside the vacuum chamber for initiating and/or for controlling a clamping movement of the at least one clamping element. The movement or force provided or generated by the clamping actuator can be transferred to the at least one clamping element via the transmission rod.

According to a further example the clamping actuator comprises a hydraulic actuator. A hydraulic actuator may or should not be used inside the vacuum chamber. When located or installed inside a vacuum environment, operation of a hydraulic actuator might be rather complicated. Moreover, arrangement of a hydraulic actuator may potentially harm the surface treatment process of the substrate inside the vacuum chamber.

Therefore, and by making use of a transmission rod extending through the chamber wall the clamping actuator can be rather easily arranged and located as well as operated outside the vacuum chamber while the force effect provided by the clamping actuator can be transferred via the transmission rod into the interior of the vacuum chamber to provide a desired clamping and hence fastening or fixing between the rotatable drum and the substrate coil.

According to a further example a portion of the transmission rod is located inside the rotatable drum. The respective portion of the transmission rod, e.g., a distal end section of the transmission rod comprises a slanted mandrel section with an engagement surface, which is configured to engage a complementary shaped counter engagement surface of the least one clamping element or of a transmission spoke connected or engaged with the at least one clamping element. The clamping element of clamping element may be implemented as clamping jaws to frictionally engage with the inside sidewall of the substrate coil.

By way of a slanted mandrel section a longitudinal displacement of the transmission rod may can be transferred into a radially directed displacement of the at least one clamping element or clamping jaw. Alternatively, the clamping element may be provided on a radial outside surface of the sidewall of the rotatable drum whereas the transmission rod and/or its slanted mandrel section is located in a radial center section of the rotatable drum. Here, correspondingly shaped transmission spokes, which may be likewise provided with a complementary shaped counter engagement surface may be movably guided in a respective guiding structure as provided by the rotatable drum.

Such transmission spokes may be displaceable, e.g., slidably displaceably mounted inside the rotatable drum with respect to a radial direction. A longitudinal displacement of the slanted mandrel section of the transmission rod may then induce a respective radial displacement of the transmission spokes, which radial displacement likewise transitions into a respective radial displacement of the at least one clamping element, which may be in mechanical abutment or mechanical engagement with the at least one transmission spoke.

A movement of the at least one transmission spoke and/or of the at least one clamping element, e.g., from the release position into the clamping position may be conducted against a restoring force, such that in the absence of an engagement with the slanted mandrel section or in the absence of any otherwise mechanical engagement with the transmission rod, the clamping element is and/or remains in the release position. It may be then necessary and required to apply and to maintain a respective clamping force via the clamping actuator to bring and/or to keep the at least one clamping element in mechanical engagement with the inside sidewall of the substrate coil.

Accordingly and in a further example, a longitudinally directed displacement of the transmission rod relative to the elongated shaft is configured to initiate a radial displacement of the at least one clamping element or clamping jaw in the radial direction. A longitudinal displacement of the transmission rod along a first longitudinal direction, e.g., proximally, may induce a radially outwardly directed displacement of the at least one clamping element or clamping jaw. An oppositely directed displacement of the transmission rod, e.g., in longitudinal distal direction may allow or may initiate a radially inwardly directed displacement of the at least one clamping element or clamping jaw.

According to a further example the at least one clamping element may be mechanically connected or coupled to the clamping actuator via a mechanical transmission, e.g., including or comprising the transmission rod. The mechanical transmission may be implemented in numerous different ways. According to some examples, the mechanical transmission may be configured such, that a longitudinal displacement of the transmission rod along a first longitudinal direction as defined by the elongation of the elongated shaft, may induce a radially outwardly directed movement of the at least one clamping element. A longitudinal displacement of the transmission rod along a second longitudinal direction, e.g., opposite the first longitudinal direction may induce or may allow a radially inwardly directed movement of the at least one clamping element with respect to the rotatable drum.

According to further examples, the transmission rod may be rotatable inside the elongated shaft to transfer a torque from the clamping actuator to the mechanical transmission so as to induce a respective radial displacement of the at least one clamping element relative to the rotatable drum. Here, the mechanical transmission may be operable to transfer a driving torque as provided by the rotatable transmission rod into a radially outwardly and/or radially inwardly directed movement of the at least one clamping element.

Accordingly, the mechanical transmission may be configured to transfer a rotation of the transmission rod along a first rotating direction into a radially outwardly directed movement of the at least one clamping element. The mechanical transmission may be further configured to transfer a rotation of the transmission rod along a second rotating direction, e.g., opposite the first rotating direction, into a radially inwardly directed movement of the at least one clamping element. Here, the transmission rod may be longitudinally fixed relative to the elongated shaft.

At least one of the radially outwardly directed or radially inwardly directed displacement of the at least one clamping element may be also conducted or provided by a spring. In this way and in the absence of a force effect transmitted via the transmission rod, the at least one clamping element may be automatically shifted in one of the release position and the clamping position, typically, into the release position. Insofar and in the absence of a force effect provided by the clamping actuator, there will be allowed a replacement of the substrate coil on or with respect to the rotatable drum.

According to a further example, the transmission rod extends longitudinally through the elongated shaft. Accordingly, at least a portion of the elongated shaft is implemented as a hollow shaft portion. The hollow interior of the shaft may be configured to receive the transmission rod therein and/or therethrough in longitudinal direction. In addition, the transmission rod may be slidably engaged with the elongated shaft in longitudinal direction of the elongated shaft. Accordingly, the transmission rod may be longitudinally displaceable inside the elongated shaft in order to induce or to initiate a respective movement of the at least one clamping element between the release position and the clamping position.

The transmission rod may be arranged coaxial with the elongated shaft. In this way and by keeping the transmission rod inside the elongated shaft there is only provided a single rotary feedthrough and hence a single airtight or liquid tight intersection through the chamber wall, which serves both, a rotation of the rotatable drum as well as a clamping of the rotatable drum and the substrate coil.

According to a further example, the substrate transportation arrangement further comprises a clamping controller, which is coupled to the clamping actuator and which is configured to regulate a clamping force exertable by the clamping element onto the substrate coil. The clamping controller may be electrically connected to the clamping actuator and may keep track of the force effect generated or provided by the clamping actuator. Moreover, the force effect or force generated by the clamping actuator may be monitored by at least one of a separate sensor or measuring device. In effect, there may be provided a control loop comprising or including the clamping actuator, the controller and the optional measuring device as well as an optional regulator.

By way of the measuring device, a force effect exerted by the clamping actuator can be measured and compared with a predefined clamping force or clamping range. If a clamping force measurable by the measuring device is located outside the predefined clamping force or outside a clamping range, the controller may be configured to manipulate operation of the clamping actuator so as to decrease or increase the clamping force exerted by the clamping actuator. In some examples, there may be provided a regulator, which is configured to transfer control signals generated by the controller in response to the measurement signals provided by the measuring device for controlling the clamping actuator accordingly.

In this way, and during a substrate transport conducted or provided by the substrate transportation arrangement there can be maintained a rather constant mechanical engagement between the rotatable drum and the substrate coil. The clamping force to be exerted by the clamping element onto the substrate coil may be kept in a predefined range so as to maintain a predefined tension of the strip of substrate material, which is coiled onto the substrate coil and/or which is uncoiled from the substrate coil.

On the other hand, the clamping force between the rotatable drum and the substrate coil may be adapted to prevent any slippage between the rotatable drum and the substrate coil. This way, the substrate transportation can be controlled rather reliably and failure safe.

According to some examples, a slip free fixing of the substrate or substrate coil to the rotatable drum may be also achieved by providing a clamping mechanism in or inside the rotatable drum for fastening a longitudinal end section of the substrate to the rotatable drum. Here, the outside surface of the drum may be provided with an elongated slit, e.g. extending almost entirely across the axial elongation of the drum and being sized to receive a longitudinal end of the substrate.

Inside the elongated slit there may be provided a clamping arrangement by way of which a longitudinal end of the substrate can be fixed inside the elongated slit, e.g., after entering the respective elongated slit from outside. Such a fixing or clamping arrangement may be particularly provided and/or implemented for a coiling station by way of which the surface-treated elongated strip- or band-shaped substrate can be initially fixed at least during the first initial turns of the rotating drum of the coiling station when starting to coil up the substrate.

According to a further example, the substrate transportation arrangement comprises a rotary feedthrough for sealingly guiding the elongated shaft through the chamber wall. By way of the rotary feedthrough, the rotational motion of the elongated shaft can be generated outside the vacuum chamber, e.g., by the drive, and can be hence transferred into the interior of the vacuum chamber so as to rotate the rotatable drum inside the vacuum environment.

By way of the rotary feedthrough, the elongated shaft can be driven and/or rotated by the drive, which is located outside the vacuum chamber and the respective end, e.g., an inside located distal end of the shaft can be rotated inside the vacuum chamber without the necessity to install a respective drive inside the vacuum chamber. This allows to make use of a rather cost-efficient drive, which would be otherwise unsuitable for arrangement inside a vacuum chamber.

According to another example the substrate transportation arrangement comprises at least a first pivot bearing configured for arrangement outside the vacuum chamber to rotationally support the elongated shaft outside the vacuum chamber. By providing a first pivot bearing outside the vacuum chamber, there can be provided a rotational support and hence a rotational bearing of the elongated shaft outside the vacuum chamber. Any mechanically engaged parts necessary for providing a rotational motion of the elongated shaft and hence of the rotatable drum can be thus provided outside the vacuum chamber thus avoiding a rather complex and delicate installation of such rotational bearings inside the vacuum chamber.

Moreover, and according to some examples, it is conceivable, that the rotatable drum is exclusively mechanically supported outside the vacuum chamber. Here, the elongated shaft may be mechanically supported exclusively outside the vacuum chamber such that a free and longitudinal end of the elongated shaft is located inside the vacuum chamber. Here, it may be only and exclusively a distal longitudinal portion of the elongated shaft, which is located distally from the at least one rotational bearing that is located entirely inside the vacuum chamber. In this way, and for rotating the rotatable drum inside the vacuum chamber, there may not be required any further movable components, such as bearings on which the rotatable shaft or elongated shaft would have to be mechanically or pivotally supported. Rather, it may be a distally located free end section of the elongated shaft, that intersects the chamber wall and which may provide a respective rotational support for the rotatable drum.

Accordingly, and with further examples, the longitudinal portion of the elongated shaft, which his located inside the vacuum chamber is void of a rotational support or bearing.

According to a further example the substrate transportation arrangement further comprises at least a second pivot bearing configured for arrangement outside the vacuum chamber at a longitudinal distance from the at least first pivot bearing with respect to an elongation of the elongated shaft to rotationally support the elongated shaft outside the vacuum chamber.

In this way, the elongated shaft may be pivotally supported twice outside the vacuum chamber, thus allowing to improve a rather precise pivotal and/or rotational support of the elongated shaft while simultaneously reducing the overall complexity of the rotational support of the respective elongated shaft. Moreover, by way of a first and a second pivot bearing located at a longitudinal distance, i.e., at a distance extending along the rotational axis or central axis of the elongated shaft, the total weight of the elongated shaft and the drum with the optional substrate coil attached there to or mounted thereon can be distributed among the first and the second pivot bearings. In this way, the mechanical load that has to be provided by any of the pivot bearings can be reduced accordingly and the respective geometric dimensions and load requirements for the individual first and second pivot bearings can be decreased, thus allowing to make use of rather cost efficient and commercially available pivot bearings.

According to a further example the substrate transportation arrangement comprises a deflection roller within the vacuum chamber for redirecting a substrate transportation direction. By way of a deflection roller, the overall orientation of the substrate transport direction can be changed inside the vacuum chamber. This allows to vary from a substantial horizontal substrate transport to a substantial vertical substrate transport and vice versa, from a substantial vertical substrate transport to a substantial horizontal substrate transport. With a vertical substrate transport, the overall footprint or size requirements for the installation of a respective substrate treatment system equipped with the substrate transportation arrangement can be substantially reduced, thus reducing the surface requirements and reducing the minimum installation space for installing such substrate treatment systems.

In addition, I vertically directed substrate transport may be particularly suitable for a simultaneous and double-sided treatment of the elongated substrate. Hence, both sides of the elongated substrate may be subject to a simultaneous treatment, e.g., a pretreatment, a heating or coating. Here, and due to the vertical transport direction any gravitational effects will be symmetrically present on both sides of the substrate.

Moreover, by way of a deflection roller, the substrate transportation direction can be almost freely adapted to geometric requirements as defined by the associated substrate treatment system.

According to a further example the deflection roller is rotationally supported by a load limiting bearing, which is configured to dislocate the defection roller when a tensile load on the substrate along the substrate transport direction exceeds a predefined maximum tensile strength threshold. With a deflection roller, the tensile strength applied to the substrate strip during transportation may directly or indirectly lead to a respective load acting in radial direction onto the deflection roller and hence in radial direction onto a respective load limiting bearing. In order to prevent an uncontrolled rupture of the elongated substrate it may be provided that the load limiting bearing itself starts to dislocate when a tensile strength across or along the substrate exceeds or reaches a predefined maximum tensile strength threshold.

With a comparatively large tensile strength along the substrate and when redirected by the deflection roller, the defection roller is subject to a respective radially directed force effect. With a load limiting bearing of the deflection roller there can be automatically provided a dislocation and hence a movement of the respective bearing or of the respective deflection roller such that the tensile strength along the substrate strip is abruptly reduced, thereby also reducing a risk of rupture. The dislocation of the defection roller may be further detected by at least one of the drive and the clamping actuator, which may be switched into a failure mode or emergency mode and which may abruptly stop in order to prevent a damage of the substrate or substrate strip.

In another aspect the present disclosure further relates to a substrate treatment system for treatment of an elongated substrate, e.g., of a substrate band or of a substrate strip. The substrate treatment system comprises a vacuum chamber, which is confined by a chamber wall. The substrate treatment system further comprises at least one surface treatment module for treatment of a surface of the elongated substrate under vacuum conditions. The substrate treatment system further comprises a substrate transportation arrangement as described above. Here, the rotatable drum of the substrate transportation arrangement is arranged within the vacuum chamber and hence inside the vacuum chamber. The drive to initiate and/or to control a rotation of the rotatable drum is arranged outside the vacuum chamber. Accordingly, the elongated shaft of the substrate transportation arrangement intersects the chamber wall. In some examples, a through opening extending through the chamber wall may be provided with a rotary feedthrough for sealingly guiding the elongated shaft through the chamber wall. In this way, a torque initially provided or generated by the drive located outside the vacuum chamber can be transferred into the interior of the vacuum chamber by way of the rotating elongated shaft extending through and hence intersecting the chamber wall, e.g., by way of the rotary feedthrough.

Since the substrate treatment system comprises a substrate transportation arrangement as described above, all features, effects and benefits as described above in connection with the substrate transportation arrangement equally apply to the substrate treatment system.

The at least one surface treatment module may comprise at least one of a pretreatment, a cleaning, a heating as well as a coating module for conducting a respective surface treatment of the elongated substrate. Any of the surface treatment modules may be implemented for a single-sided and/or for a double-sided treatment of the substrate, which may be continuously or step wisely transported and hence moved along the substrate transport direction through the at least one surface treatment module.

According to a further example the surface treatment system comprises at least one of an uncoiling station and a coiling station. The at least one of the uncoiling station and the coiling station comprises the rotatable drum of the substrate transportation arrangement as described above, wherein the rotatable drum is arranged within the vacuum chamber and hence inside the at least one of the uncoiling station and the coiling station. The at least one of the uncoiling station and the coiling station comprises the elongated shaft rotatably connected to the rotatable drum and intersecting the respective chamber wall.

The at least one of the uncoiling station and the coiling station further comprises the drive of the substrate treatment system, which is positioned outside the vacuum chamber of the respective coiling station or uncoiling station. Here, the drive is coupled to the elongated shaft to initiate and/or to control a rotation of the rotatable drum via the elongated shaft. The substrate treatment system may comprise an uncoiling station. It may comprise at least one surface treatment module adjacent to the uncoiling station.

The substrate treatment system may further comprise a coiling station adjacent to the at least one surface treatment module at a sidewall portion that faces away the uncoiling station. Accordingly, by way of the uncoiling station, the substrate coil can be uncoiled and a respective substrate strip can be transferred and moved towards, into and through the at least one surface treatment module adjoining the coiling station. Once a strip of material has transferred from the uncoiling station through the at least one surface treatment module to reach the coiling station, the substrate can be engaged with both, the uncoiling station and the coiling station.

The coiling station and the uncoiling station, e.g., respective rotatable drums of the uncoiling station and the coiling station may be then rotated correspondingly, so as to provide a smooth, e.g., a continuous and/or stepwise movement and hence transportation of the band-shaped or strip-shaped substrate from the uncoiling station through the at least one surface treatment module to the coiling station.

Accordingly and with a further example of the substrate treatment system, the substrate treatment system comprises both, an uncoiling station and a coiling station. Here, the uncoiling station comprises a first rotatable drum, a first elongated shaft and a first drive as described above. The coiling station may comprise a second rotatable drum, a second elongated shaft and a second drive as described above. Here, both, the uncoiling station as well as the coiling station comprise a respective uncoiling rotatable drum and a coiling rotatable drum, which are movable and hence rotatable by way of first and a second drives, which are located outside the uncoiling station and outside the coiling station, respectively.

According to a further example the chamber wall of at least one of the uncoiling station and the coiling station comprises a loading aperture, which is sized to receive the substrate coil there through. The loading aperture may be provided as an aperture in the chamber wall. The loading aperture may be provided in a sidewall of the chamber wall, which extends substantially perpendicular to the axis of rotation of the rotatable drum. In this way and by opening the loading aperture, an entire substrate coil may be inserted into the vacuum chamber of an uncoiling station. Accordingly, a complete substrate coil, which has been coiled during substrate transportation in or with the coiling chamber may be removed from the coiling chamber through the respective loading aperture.

The loading aperture may be sealable and/or closable by a lid or closure. The loading aperture may be provided with a pivoting or sliding door.

According to a further example the substrate treatment system comprises a substrate alignment control for controlling at least one of a position and an orientation of the elongated substrate transverse to the substrate transport direction. The substrate alignment control comprises a deflection roller rotatable with respect to an alignment control axis. Here, an orientation or direction of the alignment control axis is adjustable. The orientation or direction of the alignment control axis may be tunable and may slightly deviate from a strict transverse or perpendicular direction as seen with respect to the substrate elongation or overall substrate moving direction. In this way, the transverse position and/or a respective orientation of the substrate transport can be adjusted and kept within a predefined range.

The alignment control axis and/or the bearing of the at least one deflection roller of the substrate alignment control may be movable at least at one longitudinal end and may be pivotable at an opposite longitudinal end so as to modify the orientation or direction of the alignment control axis and/or of the respective deflection roller.

According to some examples the alignment control axis may be movable or reorientable in a plane defined by the substrate transport direction and the substrate cross direction, hence in a plane extending substantially perpendicular to the surface normal of the planar substrate. The alignment control axis and that all the respective bearing defining the alignment control axis may be supported and/or defined by a frame, wherein the frame itself is deflectable to a predefined extend. Hence, portion of the frame of the substrate alignment control, which is provided with the alignment control axis is movable, e.g. resiliently movable relative to another portion of the frame, hence relative to another and oppositely located end portion of the frame.

The displacement of at least one portion of the alignment control axis and/or of the respective deflection roller may be provided by an alignment actuator, which may be located outside the vacuum chamber. Also here, there may be provided an adjustment rod by way of which a mechanical movement, displacement or torque as generated by the alignment actuator can be transferred across and through the chamber wall. Also here, the mechanical displacement or torque inducible by the alignment actuator may be transferred from outside the vacuum chamber through a feedthrough, e.g., by a rotary feedthrough through the chamber wall so as to modify a position and/or an alignment or orientation of the alignment control axis of the substrate alignment control.

According to some examples, the frame of the substrate alignment control may be deflectable or bendable against an intrinsic restoring force. Accordingly, and in the absence of a force effect from the alignment actuator the substrate alignment control may be in an initial or idle configuration. The substrate alignment axis may be deflectable in a first and/or second transverse direction, which may be opposite directions, so as to reorient the substrate alignment axis to provide a respective alignment correction of the substrate.

The substrate alignment control may be further provided with at least one position sensor by way of which a lateral position of the substrate can be quantitatively measured answers or controlled. The position sensor may be implemented as one of an optical sensor, as an inductive sensor and as a radar-based sensor. There may be further provided an alignment controller, which is connected to the position sensor and which is operable to evaluate signals or data obtainable from the position sensor. The alignment control may be further operable to activate answers or to operate an adjustment of the substrate alignment axis in order to keep the lateral position of the substrate within a predefined range.

According to some examples the load limiting bearing may be implemented or integrated into the substrate alignment control. In this way, the substrate alignment control may provide both, a correction or adjustment of the substrate position in a direction transverse or perpendicular to the general substrate transportation direction or substrate elongation as well as to provide a load limiting in order to prevent an uncontrolled rupture of the strip of substrate material inside the vacuum chamber.

According to a further aspect, the present disclosure also relates to a method of treating a substrate in a vacuum chamber. The method comprises the steps of arranging of a substrate coil on a rotatable drum of a substrate transportation arrangement as described above inside a vacuum chamber of a substrate treatment system as described above. The method further comprises the step of uncoiling the substrate coil and/or uncoiling the substrate coil by transporting the elongated substrate along a substrate transportation direction towards and through the at least one surface treatment module of the substrate treatment system.

The method of treating the substrate and/or of moving or transporting the substrate is typically to be conducted by a substrate treatment system, e.g., implemented as a substrate coating system, wherein the substrate treatment system is equipped or provided with at least one substrate transportation arrangement as described above. Insofar, the method of treating and/or of transporting the substrate may be conducted by the substrate treatment system as described above in connection with the substrate transportation arrangement as described above.

Insofar, all features, effects and benefits as described above in connection with any of the substrate transportation arrangement and the substrate treatment system equally apply to the method of treating the substrate in a vacuum chamber; and vice versa.

### Brief description of the drawings

Further features, effects and benefits to be obtained by a substrate transportation arrangement and/or by a substrate treatment system or by a method of treating a substrate in a vacuum chamber will be described in greater detail by making reference to the drawings in which:
Fig. 1 shows a schematic illustration of an example of a substrate transportation arrangement before a substrate coil is arranged on a respective rotatable drum,
Fig. 2 shows the substrate transportation arrangement with a substrate coil duly attached or mounted on the rotatable drum,
Fig. 3 shows a portion of the substrate transportation arrangement,
Fig. 4 shows another portion of the substrate transportation arrangement,
Fig. 5 shows a further cross-section through the substrate transportation arrangement,
Fig. 6 is a flowchart of a method of treating a substrate by making use of the substrate transportation arrangement,
Fig. 7 is a further schematic illustration of the rotatable drum,
Fig. 8 is another illustration of the rotatable drum with a substrate coil mounted thereon,
Fig. 9 is a schematic example of an uncoiling station,
Fig. 10 shows an example of a substrate treatment system including a substrate transportation arrangement,
Fig. 11 is a further example of a substrate treatment system,
Fig. 12 schematically shows an example of a substrate alignment control provided with a load limiting bearing in an initial configuration,
Fig. 13 shows the substrate alignment control in an emergency and load limiting configuration,
Fig. 14 is a schematic illustration of a substrate alignment control, and
Fig. 15 is a further illustration of the substrate alignment control in a deflected configuration.

### Detailed description

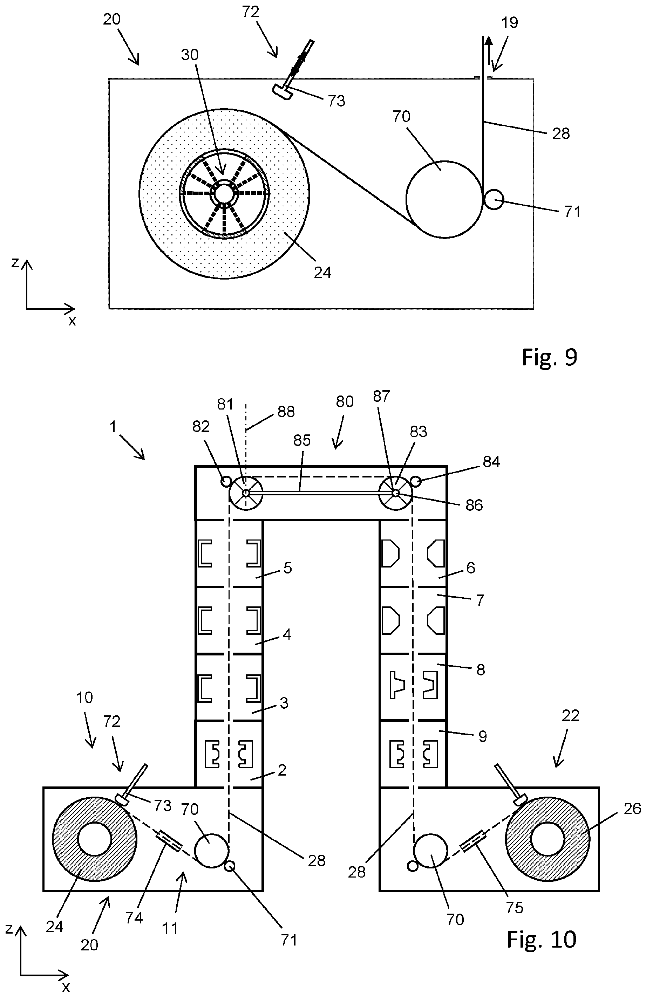

In Fig. 10 there is illustrated an example of a substrate treatment system 1, which may be implemented as a substrate coating system. The illustrated example of the substrate treatment system 1 comprises numerous surface treatment modules 2, 3, 4, 5, 6, 7, 8, 9, which are arranged in line, i.e. adjacently next to each other along a substrate transportation direction. The substrate treatment system 1 comprises a vacuum chamber 11. In the illustration according to Fig. 10, the substrate treatment system 1 may comprise clamp lock module 2 followed by a pretreatment module 3, 4, 5 by way of which the moving substrate 28 may be treated, e.g. heated, and/or provided with a seed layer.

The substrate treatment modules 2, 3, 4, 5 are arranged vertically on top of each other. This allows for a double-sided and simultaneous treatment of both oppositely located surfaces of the band-shaped or strip-shaped elongated substrate 28. Moreover, a vertical substrate transport may be less susceptible to contamination, e.g. by particles inside the vacuum atmosphere inside the vacuum chamber 11. Further surface treatment modules 6, 7 may be implemented as coating modules. Here, the substrate 28 may be subject to a coating process, which may be implemented or provided by physical vapor deposition.

The surface treatment module 8 may comprise or may be implemented as a sample extractor. Here, the substrate 28 may be analyzed. Specifically, and by extracting a portion of the substrate 28 a quality or structure of the coating applied to the surface of the substrate 28 may be analyzed.

Moreover, further substrate characteristics, such as substrate thickness, substrate roughness or geometric dimensions or tolerances of the substrate 28 may be measured.

The substrate 28 may be provided as an endless band or belt and hence as a longitudinal strip of material. The substrate 28 may be provided in form of a coil 24 in an uncoiling station 20. Here, the coil 24 of the substrate may be uncoiled so as to be moved or fed through the sequence of substrate treatment and hence a surface treatment modules 2, 3, 4, 5, 6, 7, 8, 9. The final substrate treatment module 9, which may implemented as another clamp lock module, may be located adjacent a coiling station 22, which is configured to coil the substrate 28 onto a coil 26.

The uncoiling station 20, the coiling station 22 as well as any one of the surface treatment modules 2, 3, 4, 5, 6, 7, 8 may be each provided with a flange 19, through which neighboring or adjacently located surface treatment modules 2, 3, 4, 5, 6, 7, 8 as well as the uncoiling station 20 and the coiling station 22 can be mutually connected in a vacuum tight manner. Hence, the vacuum chamber 11 may continuously extend from the uncoiling station 20, through the adjacently located treatment modules 2, 3, 4, 5, 6, 7, 8 into the substrate coiling station 22. Of course, there may be provided a vacuum pump, by way of which a vacuum atmosphere of desired vacuum pressure can be generated and controlled inside the vacuum chamber 11.

A raw or untreated substrate, e.g., in form of a steel coil, may be provided in form of an initial coil 24 and the substrate treatment system 1 may provide a desired surface treatment of the uncoiled substrate 28 as it is moved sequentially through the sequence of surface treatment modules 2, 3, 4, 5, 6, 7, 8, 9 until it reaches the coiling station 22, where the surface-treated band-shaped and/or strip-shaped substrate 28 is coiled onto a treated substrate coil 26.

The uncoiling station 20 as well as the coiling station 22 are both provided with a deflection roller 70, which is located at a predefined distance from the respective coils 24, 26. In this way, the overall substrate transport direction can be redirected. In the uncoiling station 20, the coil 24 is uncoiled in a substantially horizontal orientation. It may be then deflected upwardly towards the first surface treatment module 2 through its guidance around the deflection roller 70. The deflection roller 70 may be further provided with a guiding roller 71, by way of which there can be provided a secure and failure safe substrate guiding around the deflection roller 70. The guiding roller 71 provides a kind of a clamping of the substrate strip 28 as it is guided around the deflection roller 70. This helps to maintain and/or to fix the substrate 28 even in case of a substrate rupture and during maintenance of the entire system.

The uncoiling station 20 is further provided with a substrate connector 74. Here, and when the substrate 28 has been entirely uncoiled from the coil 24 there may be provided another new coil and the band or strip of substrate 28 from the new coil may be then connected to the end portion of the previous coil to provide a kind of an endless band or endless strip transport through the arrangement of the surface treatment modules 2, 3, 4, 5, 6, 7, 8, 9. Likewise and correspondingly, the coiling station 22 is provided with a substrate disconnector 75 by way of which a surface treated substrate coil 26 can be disconnected from the endless substrate belt or substrate strip 28 so as to remove the respective coil 26 from the coiling station 22.

At least one of the uncoiling station 20 and the coiling station 22 is provided with a strap securing 72 by way of which an uncontrolled coiling or uncoiling of the coil 24, 26 could be blocked or prevented. As indicated in Fig. 10, the strap securing installation 72 may comprise a movable plunger 73, to engage with the outermost layer or wrap of the coil 24, 26. The inside facing end of the plunger 73 may engage an outside facing structure of the respective coil 24, 26 thereby inducing a respective braking effect on the rotatable coil 24, 26 to impede or to block an uncontrolled rotational motion of the respective coil 24, 26.

The substrate transportation arrangement 10 comprises the uncoiling station 20 and the coiling station 22 to uncoil and to coil the elongated or band-type substrate 28.

The uncoiling station 20 and the coiling station 22 both comprise a rotatable drum 30, which is configured to hold at least a part of the substrate in a coiled configuration, i.e., as a substrate coil within the vacuum chamber 11. Both, the uncoiling station 20 as well as the coiling station 22 may be provided with a similar or somewhat identically shaped or identically configured drum 30. The drum 30 comprises a sidewall 31, which may be of tubular shape. The drum 30 is rotatable inside the vacuum chamber 11 with respect to an axis of rotation R.

For this, the rotatable drum 30 is rotatably connected or rotatably engaged and/or rotatably supported by an elongated shaft 32. The elongated shaft 32 may provide or may constitute a driving shaft by way of which the drum 30 can be rotated with respect to the axis of rotation R.

The elongated shaft defines the axis of rotation R for or of the rotatable drum 30 and is configured to intersect the chamber wall 12, which confines the vacuum chamber 11. There is further provided a drive 38, which is coupled to the elongated shaft 32, e.g., outside the vacuum chamber. The drive 38 is configured for an operation and an arrangement outside the vacuum chamber 11. It is configured to initiate and/or to control a rotation of the rotatable drum 30 with respect to the axis of rotation R via the elongated shaft 32. This way, a torque as provided or generated by the drive 38 and configured or intended to rotate the rotatable drum 30 can be provided outside the vacuum chamber 11.

Accordingly, the drive 38, which is configured to initiate and/or to control the rotation of the rotatable drum 30 inside or within the vacuum chamber 11 is installed outside the vacuum chamber 11, which provides a rather easy, cost efficient and straightforward implementation of the drive 38.

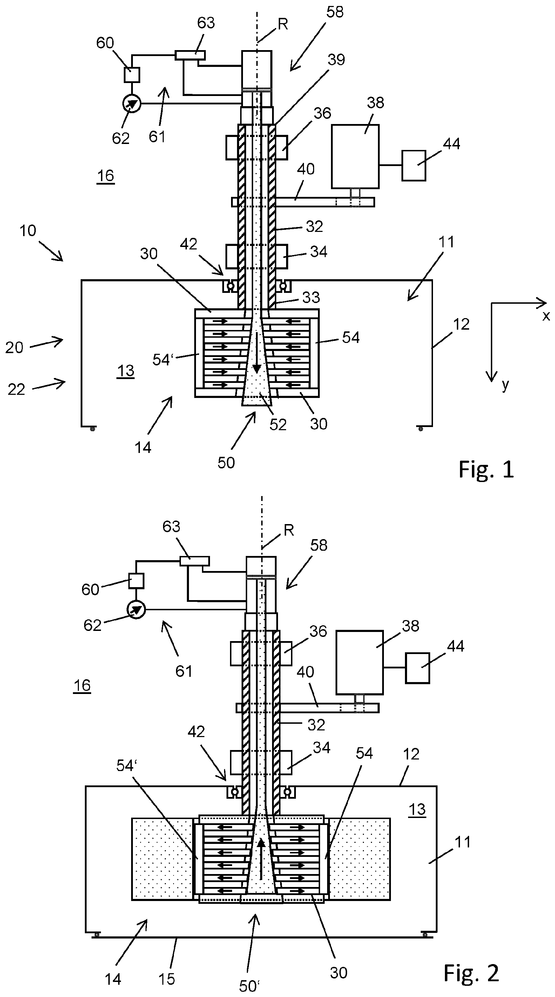

As e.g. illustrated in Figs. 1 2, the drive 38 may be operated answers are controlled by a drive controller 44. A torque or force effect generated by the drive 38 may be transferred to or onto the elongated shaft 32 by way of a transmission 40. The transmission may comprise one or several gears to transfer the torque from the drive 38 onto the elongated shaft 32.

As becomes further apparent from Figs. 1-5, the elongated and rotatable shaft 32 intersects the chamber wall 12. For this, the intersection may be provided with a rotary feedthrough 42, which seals a through opening extending through the chamber wall 12 that allows and supports a rotational motion of the elongated shaft 32.

As indicated in Figs. 1 and 2, the elongated shaft 32 comprises a longitudinal distal end 33, which is connected to the rotatable drum 30. The elongated shaft 32 further comprises an oppositely located proximal longitudinal end 39. The proximal end 39 of the elongated shaft 32 is located outside the vacuum chamber 11. The distal end 33 of the elongated shaft 32 is located inside the vacuum chamber 11. The distal longitudinal end 33 is rotationally locked, i.e., rotationally fastened or fixed to the rotatable drum 30. The rotatable drum 30 may be supported, i.e. rotationally supported by the distal end 33 of the longitudinal or elongated shaft 32. The rotatable drum 30 may be exclusively supported by the elongated shaft 32. It may not be supported by any further components inside the vacuum chamber 11. In other words, the rotatable drum 30 may be installed and/or arranged inside the vacuum chamber 11 only and exclusively by the elongated shaft 32. Accordingly, the rotatable drum 30 may be supported and/or fixed to a free longitudinal end of the elongated shaft 32.

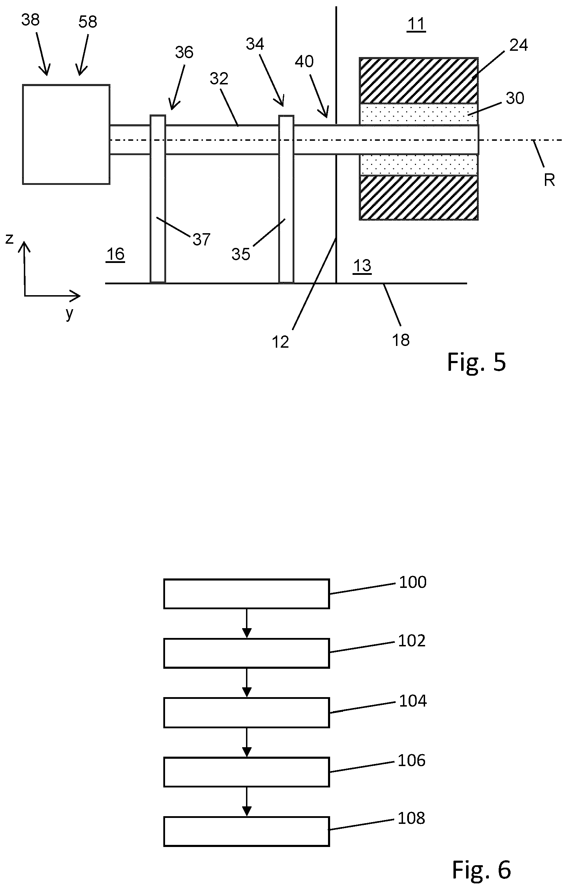

The elongated shaft 32 may be mechanically supported exclusively outside the vacuum chamber 11 as indicated in Fig. 5. For this, there may be provided a first and a second bearing 34, 36, which may be located and arranged at a longitudinal distance from each other as seen in longitudinal direction of the elongated shaft 32. The respective bearings 34, 36 may be provided at an upper end of respective supports 35, 37, which may be implemented as a support posts.

The supports 35, 37 may be located and installed on a ground surface 18 in an outside region 16 of the vacuum chamber 11. By providing two bearings 34, 36, the drum 30 can be easily mounted at a free and longitudinally protruding distal end 33 of the elongated shaft 32. The shaft 32, and in particular an intermediate portion of the shaft 32 may be in torque proof engagement with the drive 38. Accordingly, the drive 38 may be in torque proof and hence torque transmitting engagement with a middle section of the elongated shaft 32, which is located between the bearings 34, 36.

By way of the bearings 34, 36, the entire weight of the elongated shaft 32 as well as of the drum 30 and the substrate coil 24, 26 supported on or by the longitudinal end 39 of the elongated shaft 32 can be supported by the 2 bearings 34, 36. This allows to effectively remove any mechanical forces or pressure from the rotary feedthrough 42.

As further illustrated in Figs. 1-4 and 7-8, the drum 30 with its sidewall 31 further comprises at least one clamping element 54, which is movable relative to the sidewall 31 along a radial direction r with respect to the axis of rotation R between a release position and a clamping position. This way, the clamping element 54 may selectively engage with an inside sidewall 25 of the substrate coil 24, 26.

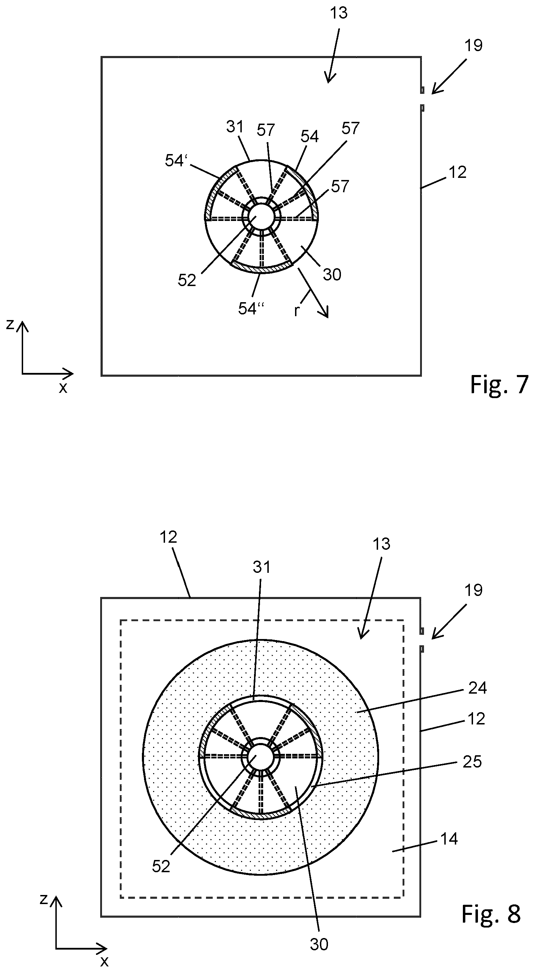

In the configuration according to Figs. 1 and 7 the clamping element 54 is in a radially inward release position. In the configuration as illustrated in Figs. 2, 4 and 8, the clamping element 54 is in the radially outwardly protruding clamping position. In the clamping position the at least one clamping element 54, e.g., implemented as a clamping jaw, protrudes radially outwardly from the sidewall 51 to engage the inside sidewall of the substrate coil 24, 26.

As becomes apparent from the cross-section of Figs. 7 and 8 there may be provided, three or even more clamping element 54, 54', 54", equiangularly or equidistantly arranged along the outer circumference of the sidewall 31 of the drum 30. In this way, there can be provided a multiple radial clamping between the drum 30 and the inside sidewall 25 of the coil 24, 26.

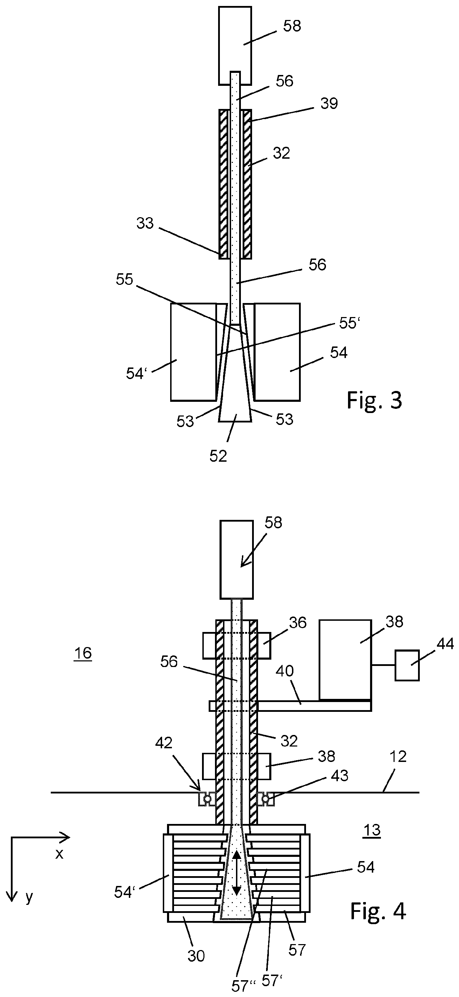

The radial movement of the clamping element 54 may be provided and/or controlled by a mandrel section 52 of a transmission rod 56 and e.g. indicated in Fig. 3. The mandrel section 52 comprises a slanted engagement surface 53 as seen in axial or longitudinal direction of the elongated shaft 32. The transmission rod 56 may be longitudinally displaceable relative to the elongated shaft 32. The transmission rod 56 may extend and reach through the hollow elongated shaft 32. It may be longitudinally displaceable relative to the shaft 32, while being axially or longitudinally fixed relative to the chamber wall 12.

By way of the longitudinally directed displacement of the transmission rod 56 and hence of the mandrel section 52 of the transmission rod 56, the engagement surface 53 engages a complementary shaped counter engagement surface 55 of the at least one clamping element 54. The slanted mandrel section 52 and hence its engagement surface 53 may simultaneously engage with multiple complementary shaped counter engagement surfaces 55, 55' of the numerous clamping elements 54, 54'. In this way, a longitudinally directed displacement of the mandrel section 52 and hence of the transmission rod 56, e.g., in proximal direction, hence towards the proximal end 39 of the elongated shaft 32, leads to a radially outwardly directed displacement of the clamping elements 54, 54', 54".

Vice versa, a distally directed displacement of the transmission rod 56 and is mandrel section 52 relative to the rotatable drum 30 e.g., in distal direction leads to a radially inwardly directed displacement of the clamping element 54. The radially inwardly directed displacement of the clamping element 54 or clamping elements 54, 54', 54" may be supported or induced and/or initiated by a spring element provided by way of which the clamping element 54 may be biased radially inwardly. The proximally directed displacement of the transmission rod 56 may urge the clamping elements 54, 54', 54" radially outwardly against the action of a respective spring element (not illustrated).

The clamping elements 54, 54', 54" may be directly provided with the complementary shaped counter engagement surface 55 at a radial inside section or at a radially inwardly facing section to engage with the respective radially outwardly facing slanted mandrel section 52 and/or with the engagement surface 53.

In some examples it may be provided, that the clamping elements 54, 54', 54" are mechanically engageable with the mandrel section 52 by a number of radially extending transmission spokes 57, as e.g. indicated in Figs. 1, 2, 4, 7 and 8. Here, there may be provided numerous longitudinally shaped and radially oriented transmission spokes 57 having an inside facing slanted end, which is complementary shaped to the geometry of the engagement surface 53 of the slanted mandrel section 52 of the transmission rod 56. A radial outside end of the transmission spokes 57 is in engagement or abutment with a radial inside portion of the respective clamping element 54, 54', 54".

A longitudinal displacement of the transmission rod 56 relative to the elongated shaft 32 can be initiated and/or controlled by a clamping actuator 58, which may be also arranged outside the vacuum chamber 11. The clamping actuator 58 may be attached to and/or arranged at the proximal end of the elongated shaft 32. The clamping actuator 54 may be implemented as a hydraulic actuator. It may be controllable by a control loop 61 comprising a measuring device 62, a clamping controller 60 and a regulator 63. The measuring device 62 may be configured to measure a force effect, e.g., a hydraulic pressure acting on the clamping actuator 58.

The measuring device 62 is connected in a signal transmitting manner with the clamping controller 60. The clamping controller 60 may be configured to operate, to initiate or to control the clamping regulator 63, which induces or controls the force generated by the clamping actuator. The clamping control loop 61 and the controller 60 may be configured to control the clamping pressure or clamping force of the clamping elements 54, 54' acting on the inside surface 25 of the substrate coil 24, 26. The respective clamping force may be controlled and/or regulated so as to provide and/or to maintain an optimal clamping force between the drum 30 and the coil 24, 26. In this way, there can avoided any uncontrolled slippage between the coil 24, 26 and the respective drum 30.

Also, the drive 38 may operated and/or controlled by the drive controller 44. The drive controller 44 may be connected to the clamping controller 60. Moreover, the substrate transportation arrangement may comprise at least one or numerous sensors, capable to measure an actual substrate transportation velocity inside the vacuum chamber 11. The substrate moving sensor or substrate velocity detector, and hence the drive controller 44 and the clamping controller 60 may be connected and may form a further regulation loop so as to provide a slip free clamping of the substrate coil 24, 26 during and/or for substrate transportation.

The mutual coupling or connection of the controllers 44, 60 with the substrate moving velocity may allow to detect a slipping between the rotation of the elongated shaft 32 and hence of the drum 30 relative to the substrate coil 24, 26. In case of a mismatch between the measured substrate velocity and the angular velocity of the substrate coil 24, 26 with a given coil diameter the clamping controller 60 may increase a contact or clamping pressure between the drum 30 and the substrate coil 24, 26.

The uncoiling station 20 and the coiling station 22 each comprise a loading aperture 14 in the chamber wall 12 for loading and unloading of a substrate coil 24, 26. The loading aperture 14 may be provided and arranged in a sidewall of the chamber wall 12 that extends perpendicular to the axis of rotation R of the elongated shaft 32. The loading aperture 14 may be located or provided in a sidewall section that is located or arranged opposite the portion of the chamber wall 12, which is intersected by the elongated shaft 32. In this way the substrate coil 24, 26 can be loaded or unloaded in a direction parallel or coaxial with the axis of rotation R.

The loading aperture 14 is closable by a closure 15, which may be implemented as a door or as a lid detachably or movably arranged relative to the loading aperture 14. Of course, the closure 15 is configured to hermetically seal the loading aperture 14. It may be provided with a respective seal.

When the closure 15 is duly arranged in a closing position or closing arrangement the loading aperture 14 is effectively sealed against ingress of air or any contaminants into the interior 13 of the vacuum chamber 11.

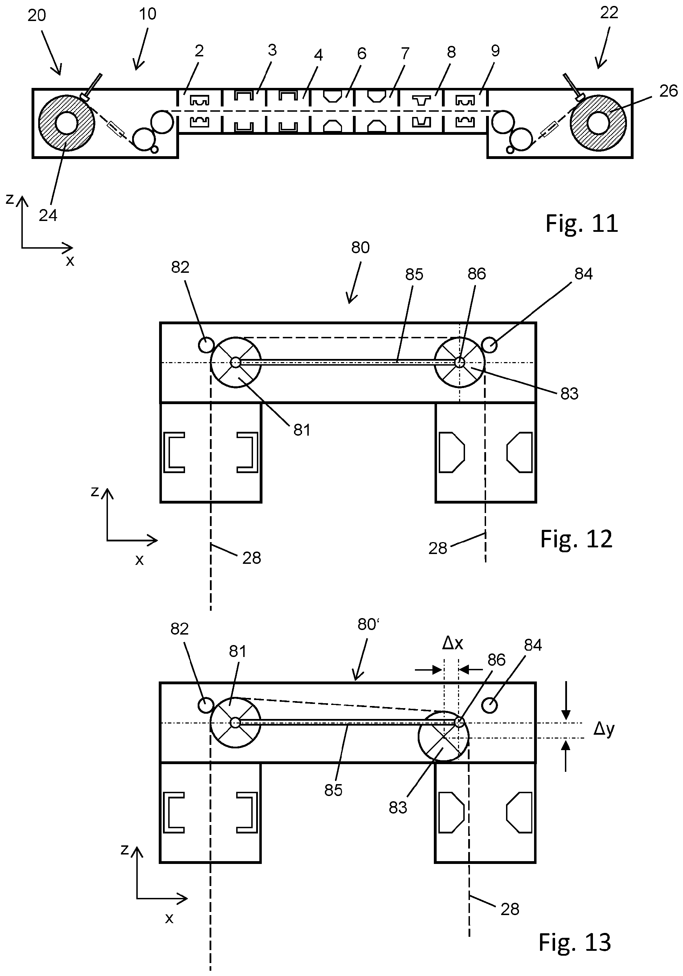

In Fig. 11 there is illustrated one example of a substrate treatment system 1, which is completely arranged in line or along a longitudinal substrate transport direction, e.g., extending along an x-axis. The substrate treatment system 1 according to Fig. 11 comprises uncoiling station 20 with a first substrate coil 24 and a coiling station 22 comprising another substrate coil 26. The substrate 28 is uncoiled from the substrate coil 24 in the uncoiling station 20. The substrate 28 is continuously or stepwise transported through an arrangement of at least one substrate treatment module 2, 3, 4, 6, 7, 8, 9 before the substrate 28 is then coiled onto the substrate coil 26 within the coiling station 22.

The arrangement of a number of surface treatment modules 2, 3, 4, 5, 6, 7,8, 9, as well as their mutual arrangement or order of arrangement may vary in accordance to the substrate treatment process. In some examples it may be provided that the substrate 28 is pretreated by discrete pretreatment modules 3, 4. By way of the modules 6, 7 the substrate may be coated. The substrate treatment module 8 may be implemented as a sample extractor by way of which a portion of the substrate 28 can be extracted from the substrate 28 for process control and analysis. The substrate modules 2, 9 may be implemented as clamping locks.

When the substrate 28 is implemented as or comprises a band of steel it might be difficult to maintain a horizontal alignment of the substrate 28 as the substrate 28 is transported through the arrangement of substrate treatment modules 2, 3, 4, 6, 7, 8, 9. Accordingly, the substrate 28 may be kept under a significant tensile strength along the substrate transport direction.

With the example of Fig. 10 and by way of the deflection roller 70 as provided in both, the uncoiling station 20 and the coiling station 22 there can be provided at least a a section of a vertically oriented substrate transport, e.g. extending parallel to the vertical direction (z). Here, the effect of gravity has no influence on the substrate transportation direction as the substrate 28 is transported substantially vertically, i.e., from the uncoiling station 22 to the surface treatment module 5. Moreover, from the surface treatment module 6 towards the coiling station 22 the substrate 28 may be substantially free from any gravitational forces that would lead to a deformation of the planar substrate 28 along its surface normal.

However, the substrate 28 such as steel band, may be subject to a lateral shift, e.g., in in substrate cross direction (y-direction) as the substrate 28 is transported through a series of substrate treatment modules 2, 3, 4, 5, 6, 7, 8, 9. In the example according to Fig. 10 there is provided a substrate alignment control 80, which is located between any two of the substrate treatment modules 5, 6. The separate alignment control 80 comprises a first deflection roller 81 and a second deflection roller 83. Both deflection rollers 81, 83 may be optionally provided with a guiding roller 82, 84, such that the substrate 28 is guided between the deflection roller 81 and the guiding roller 82 as well as between the second deflection roller 83 and the further guiding roller 84.

The deflection rollers 81, 83 may be arranged on a common frame 85. At least one of the deflection rollers 81, 83 is provided, i.e. rotationally supported by way of a roller bearing 86, which is shiftable or adjustable with respect to the substrate transport direction. In other words, one longitudinal end of the roller bearing 86 is adjustable in the plane perpendicular to the substrate cross direction (y). Here, and with the presently illustrated example at least one end of the alignment control axis 87 defined by the roller bearing 86 may be adjustable in a y-direction and/or in a x-direction.

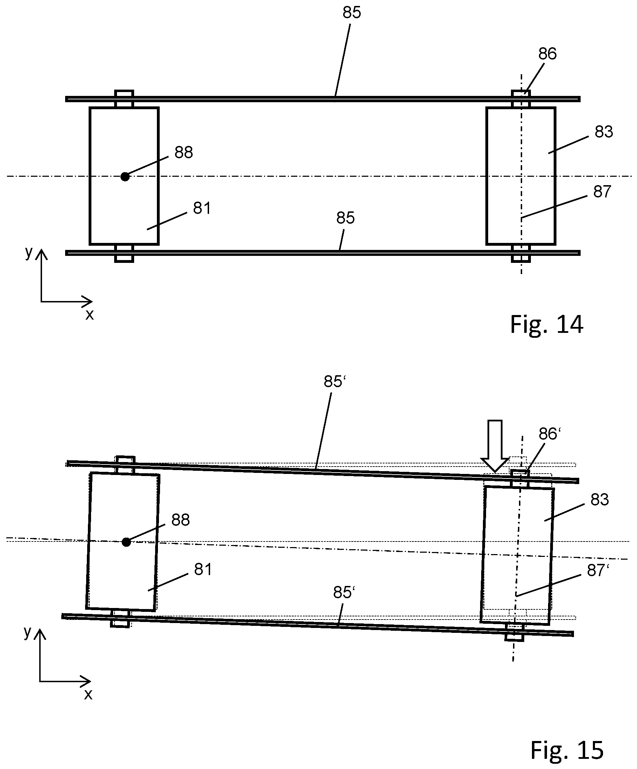

The adjustment of the alignment control axis 87, e.g., provided by the deflection roller 83 is immediately apparent from a comparison of the illustrations according to Figs. 14 and 15. Here, both deflection rollers 81, 83, which are separated along the main substrate transportation direction (x) are rotationally supported on a common frame 85. The frame 85 is bendable to a certain extend in the substrate cross direction (y). Accordingly, the position and/or orientation of the deflection roller 83 relative to the deflection roller 81 can be adjusted and/or modified in the plane as defined by the substrate transportation direction (x) and the substrate cross direction (y).

Accordingly, the alignment control axis 87' and the orientation of the bearing 86' as shown in Fig 15 is slightly tilted compared to the initial orientation of the alignment control axis 87 and the bearing 86 as shown in Fig. 14. The frame 85, e.g., a longitudinal end of the frame 85 supporting the deflection roller 83 is shiftable or displaceable relative to an opposite longitudinal end of the frame 85. Here, and by way of example, the frame 85 may be tiltable or pivotable with respect to a pivot axis 88, which may extend in vertical direction (z) through the deflection roller 81. This way, an opposite longitudinal end of the frame 85 can be shifted or moved substantially along the transverse direction (y) to thereby induce a respective lateral shift of the associated deflection roller 83, which then leads to a respective and intended alignment of the substrate.

Hence, the longitudinal end of the frame 85, which is provided with the deflection roller 83 can be shifted in substrate cross direction (y) relative to the opposite longitudinal end of the frame 85, which is provided with the other deflection roller 81. For this, there may be provided an alignment actuator, which may be mechanically engaged with the frame 85 to induce a respective deflection or movement. The alignment actuator (not illustrated) may be likewise located outside the vacuum chamber 11. A mechanical transmission between the alignment actuator and the frame 85 may be provided by a vacuum-tight feedthrough extending through and traversing the chamber wall 12. According to some examples, the alignment actuator may be engaged or mechanically coupled with one longitudinal lateral end of the axis 86 of the deflection roller 83, to thereby slightly shift or pivot the orientation of the alignment control axis 87.

In this way, the lateral alignment, i.e., the alignment of the substrate 28 in the y-direction can be adjusted as the substrate 28 is deflected by the respective deflection roller 83. With the substrate alignment control 80 the orientation or direction of the alignment control axis 87 of one of the deflection rollers 81, 83 is adjustable, i.e., one longitudinal end of the alignment control axis 87 is movable or adjustable with respect to the opposite longitudinal end of the alignment control axis 87. Therefore, the orientation or direction of the axis 87, with respect to which the deflection roller 83 is rotatable, can be adjusted for providing a substrate alignment in transverse direction (y) of the substrate, i.e., perpendicular to the substrate normal as well as perpendicular to the substrate transport direction.

According to a further example at least one of the deflection rollers 81, 83, 70 may be rotationally supported by a load limiting bearing, which in the presently illustrated example is the load limiting bearing 86, which defines the alignment control axis 87 of the deflection roller 83. The load limiting bearing 86 is configured to dislocate the respective deflection roller 83 when a tensile load on the substrate 28 along the substrate transport direction exceeds a predefined maximum tensile strength threshold.

A tensile strength, which is actually present on the substrate 28, is directly measurable at any of the deflection rollers 70, 81, 83. In order to prevent a rupture or uncontrolled disintegration of the substrate 28 and/or of any substrate guiding or substrate feeding devices as the substrate is transported between the uncoiling station 20 and the coiling station 22 the load limiting bearing 86 provides a safety or emergency stop mechanism to prevent rupture of the band-type substrate 28. Rather, the load limiting bearing 86 is configured to dislocate the associated deflection roller 83 as becomes apparent from a comparison of Figs. 12 and 13. The load limiting bearing 86might be implemented purely mechanically.

Here, it may be provided that the deflection roller 86 disconnects from the load limiting bearing 86 as the tensile load on the substrate 28 along the substrate transport direction exceeds the predefined maximum tensile strength. In the load limiting case and when the deflection roller 83 is dislocated from the load limiting bearing 86 the deflection roller 83 is subject to a respective offset ΔX and ΔZ relative to the load limiting bearing 86 along the x-axis or y-axis as illustrated in Fig. 13.

Due to the dislocation the tensile load on the substrate 28 will be promptly reduced. The dislocation of the load limiting bearing 86 and/or the movement of the deflection roller 83 is further detectable by a substrate movement sensor, which is further connected with at least one of the drive 38 and the drive controller 44. Accordingly, and by way of any one of the controllers 44 or the drive 38 the substrate transport can be properly stopped.

The reaction time of the load limiting bearing 86 state is much shorter and is rather direct compared to a sensor-controlled stopping operation of the driver 38 through the drive controller 44.

In the flowchart of Fig. 6 numerous steps of conducting a method of treatment of a substrate 28 inside a vacuum chamber 11 are illustrated. Here, and in a first step 100 the substrate coil 24 is mounted on a rotatable drum 30 of a substrate transportation arrangement 10 as described above. In step 102 the substrate coil 24 is uncoiled to move the substrate 28 through the arrangement of the surface treatment modules 2, 3, 4, 5, 6, 7, 8, 9. In step 104 the transported substrate 28 is duly clamped or connected on a drum 30 of the coiling station 22. In step 106 the substrate 28 is transported through the arrangement of substrate modules 2, 3, 4, 5, 6, 7, 8, 9 rather continuously by a controlled operation of the drives 34 of the drums 30 of the uncoiling station 20 and the coiling station 22.

When the substrate coil 24 of the uncoiling station 22 has been effectively uncoiled the clamp lock modules 2, 9 may be activated to maintain a vacuum atmosphere inside the arrangement of the further surface treatment modules 3, 4, 5, 6, 7, 8. It may be then possible to open the loading apertures 14 of the coiling station 22 and/or of the uncoiling station 22 to replace the respective substrate coils 24, 26 after disconnecting the substrate coil 26 from the substrate 28. The uncoiled substrate 28 from another substrate coil 24 arranged inside the uncoiling station 20 may be then connected to the end section of the substrate 28 that is fixed in the uncoiling station 20.

Before removing the substrate coil 26 from the coiling station 22 the substrate 28 is disconnected from the remaining substrate 28 by the substrate disconnector 75. In the uncoiling station 23 the end of a first substrate 28 uncoiled from a substrate coil 24 can be connected to an outermost cross-section of a new substrate coil 24 by the substrate connector 74.

Thereafter and in step 108, the clamp locks of the substrate treatment modules 2, 9 may be opened or deactivated so as to enable a further substrate transport through the substrate treatment system 1 as described above.

### Reference Numbers

- 1: substrate treatment system
- 2: surface treatment module
- 3: surface treatment module
- 4: surface treatment module
- 5: surface treatment module
- 6: surface treatment module
- 7: surface treatment module
- 8: surface treatment module
- 9: surface treatment module
- 10: substrate transportation arrangement
- 11: vacuum chamber
- 12: chamber wall
- 13: interior
- 14: loading aperture
- 15: closure
- 16: outside
- 18: ground
- 19: flange portion
- 20: uncoiling station
- 22: coiling station
- 24: coil
- 25: inside the sidewall
- 26: coil
- 28: substrate
- 30: drum
- 31: sidewall
- 32: shaft
- 33: longitudinal end
- 34: bearing
- 35: support
- 36: bearing
- 37: support
- 38: drive
- 39: longitudinal end
- 40: transmission
- 42: rotary feedthrough
- 44: drive controller
- 50: clamping arrangement
- 52: mandrel section
- 53: engagement surface
- 54: clamping element
- 55: counter engagement surface
- 56: transmission rod
- 57: transmission spoke
- 58: actuator
- 60: controller
- 61: control loop
- 62: measuring device
- 63: regulator
- 70: deflection roller
- 71: guiding roller
- 72: strap securing
- 73: plunger
- 74: substrate connector
- 75: substrate disconnector
- 80: substrate alignment control
- 81: deflection roller
- 82: guiding roller
- 83: deflection roller
- 84: guiding roller
- 85: frame
- 86: roller bearing
- 87: alignment control axis
- 88: pivot axis

## Claims

1. A substrate transportation arrangement (10) for feeding an elongated substrate (28) along a transportation direction (x, z) inside a vacuum chamber (11) confined by a chamber wall (12), the substrate transportation arrangement (1) comprising:
- a rotatable drum (30) configured to hold at least a part of the substrate (28) in a coiled configuration as a substrate coil (24, 26) within the vacuum chamber (11),
- an elongated shaft (32) defining an axis of rotation (R), rotatably connected to the rotatable drum (30) and configured to intersect the chamber wall (12),
- a drive (38) coupled to the elongated shaft (32) and configured for an operation and an arrangement outside the vacuum chamber (11) to initiate and/or to control a rotation of the rotatable drum (30) with respect to the axis of rotation (R) via the elongated shaft (32).

2. The substrate transportation arrangement (10) according to claim 1, wherein a longitudinal distal end (33) of the elongated shaft (32) is connected or fixed to the rotatable drum (30).

3. The substrate transportation arrangement (10) according to any one of the preceding claims, wherein the rotatable drum (30) comprises a sidewall (31) and at least one clamping element (54) movable relative to the sidewall (31) along a radial direction (r) with respect to the axis of rotation (R) between a release position and a clamping position to selectively engage with an inside sidewall (25) of the substrate coil (24, 28).

4. The substrate transportation arrangement (10) according to any one of the preceding claims, further comprising a clamping arrangement (50) comprising a clamping actuator (58) and a transmission rod (56) to mechanically couple the clamping actuator (58) with the at least one clamping element (54).

5. The substrate transportation arrangement (10) according to claim 4, wherein the transmission rod (56) extends longitudinally through the elongated shaft (32).

6. The substrate transportation arrangement (10) according to claim 4 or 5, further comprising a clamping controller (60) coupled to the clamping actuator (54) and configured to regulate a clamping force exerted by the clamping element (54) onto the substrate coil (24, 26).

7. The substrate transportation arrangement (10) according to any one of the preceding claims, further comprising a rotary feedthrough (42) for sealingly guiding the elongated shaft (32) through the chamber wall (12).

8. The substrate transportation arrangement (10) according to any one of the preceding claims, further comprising at least a first pivot bearing (34) configured for arrangement outside the vacuum chamber (11) to rotationally support the elongated shaft (32) outside the vacuum chamber (11).

9. The substrate transportation arrangement (10) according to any one of the preceding claims, further comprising:
- a deflection roller (70, 81, 83) within the vacuum chamber (11) for redirecting a substrate transportation direction.

10. The substrate transportation arrangement (10) according to claim 9, wherein the deflection roller (70, 81, 83) is rotationally supported by a load limiting bearing (86), which is configured to dislocate the defection roller (70, 81, 83) when a tensile load on the substrate (28) along the substrate transport direction exceeds a predefined maximum tensile strength threshold.

11. A substrate treatment system (1) for treatment of an elongated substrate (28), the substrate treatment system (1) comprising:
- a vacuum chamber (11) confined by a chamber wall (12),
- at least one surface treatment module (2, 3, 4, 5, 6, 7, 8, 9) for treatment of a surface of the elongated substrate (28) under vacuum conditions, and
- a substrate transportation arrangement (10) according to any one of the preceding claims, wherein the rotatable drum (30) of the substrate transportation arrangement (10) is arranged within the vacuum chamber (11) and wherein the drive (38) to initiate and/or to control a rotation of the rotatable drum (30) is arranged outside the vacuum chamber (11).

12. The substrate treatment system (1) according to claim 11, further comprising at least one of an uncoiling station (20) and a coiling station (22), wherein the at least one of the uncoiling station (20) and the coiling station (22) comprises:
- the rotatable drum (30) of the substrate transportation arrangement (10) arranged within the vacuum chamber (11),
- the elongated shaft (32) rotatably connected to the rotatable drum (30) and intersecting the chamber wall (12), and
- the drive (38) positioned outside the vacuum chamber (11) and coupled to the elongated shaft (32) to initiate and/or to control a rotation of the rotatable drum (30) by of the elongated shaft (32).

13. The substrate treatment system (1) according to claim 12 and comprising:
- the uncoiling station (20) comprising a first rotatable drum (30), a first elongated shaft (32) and a first drive (38), and
- the coiling station (22) comprising a second rotatable drum (30), a second elongated shaft (32) and a second drive (38).

14. The substrate treatment system (1) according to any one of the preceding claims 11-13, further comprising a substrate alignment control (80) for controlling at least one of a position and an orientation of the elongated substrate (28) transverse (y) to the substrate transport direction, the substrate alignment control (80) comprising a deflection roller (83) rotatable with respect to an alignment control axis (87), wherein an orientation or direction of the alignment control axis (87) is adjustable.

15. A method of treating a substrate in a vacuum chamber (11) comprising the steps of:
- arranging of a substrate coil (24, 26) on a rotatable drum (30) of a substrate transportation arrangement (10) according to any one of the preceding claims 1-10 inside a vacuum chamber (11) of a substrate treatment system (1) according to any one of the preceding claims 11-14, and
- uncoiling the substrate coil (24) and/or coiling a substrate coil (26) by transporting the elongated substrate (28) along a substrate transportation direction (x, y) towards and through the at least one surface treatment module (2, 3, 4, 5, 6, 7, 8, 9).
